# EUROPEAN PATENT APPLICATION

(11) **EP 4 391 778 A1**
(43) Date of publication of application: **26.06.2024**
(21) Application number: 23202267.3
(22) Date of filing: 06.10.2023
(51) Int. Cl.: H10K 59/80

(54) **DISPLAY DEVICE AND METHOD FOR MANUFACTURING THE SAME**

(30) Priority: 19.12.2022 KR 20220178426
(71) Applicant: Samsung Display Co., Ltd., Yongin-si, Gyeonggi-do 17113 (KR)
(72) Inventor: KIM, Seung Hun, 17113 Yongin-si (KR); LEE, Jeong Seok, 17113 Yongin-si (KR); PARK, WOOCHEOL, 17113 Yongin-si (KR); SONG, Seung Yong, 17113 Yongin-si (KR); YANG, Hee Jun, 17113 Yongin-si (KR); YOON, Kwan Hyuck, 17113 Yongin-si (KR); LEE, CHANGHEE, 17113 Yongin-si (KR)
(74) Representative: Taor, Simon Edward William

(57) **Abstract**

The present disclosure relates to a display device and a method for manufacturing the same. A display device, according to an embodiment, includes: a substrate (110); a thin film transistor (TFT) on the substrate (110); a first electrode (191) connected to the thin film transistor (TFT); a light emitting layer (370) on the first electrode (191); and a second electrode (270) on the light emitting layer (370). The second electrode (270) includes a metal material (5271a, 5271b, 5271c) and a graphene material (5275a, 5275b) that are mixed.

## Description

### CROSS-REFERENCE TO RELATED APPLICATION

This application claims priority to and the benefit of Korean Patent Application No. 10-2022-0178426, filed in the Korean Intellectual Property Office on December 19, 2022.

### BACKGROUND

### 1. Field

Aspects of embodiments of the present disclosure relate to a display device and a method for manufacturing the same.

### 2. Description of the Related Art

A display device is a device for displaying an image and generally includes a liquid crystal display (LCD), an organic light emitting diode (OLED) display, and the like. The display device is used in (or incorporated into) various electronic devices, such as a mobile phone, a navigation device, a digital camera, an electronic book, a portable game machine, and various terminals.

An organic light emitting display device generally includes two electrodes with an organic light emitting layer interposed therebetween. Electrons injected from one electrode and holes injected from another electrode are combined in the organic light emitting layer to generate excitons. The generated excitons are changed to a ground state from an excited state, thereby releasing energy to emit light.

An organic light emitting layer of the organic light emitting display device may, however, be vulnerable to moisture introduced from the outside. To reduce or prevent permeation of moisture to the organic light emitting layer, an encapsulation layer including an organic film and an inorganic film may be provided. But when the organic light emitting display device is bent or folded, a crack may occur in the encapsulation layer, allowing moisture to penetrate therethrough.

The above information disclosed in this Background section is for enhancement of understanding of the background of the present disclosure, and therefore, it may contain information that does not form the prior art that is already known to a person of ordinary skill in the art.

### SUMMARY

Embodiments of the present disclosure provide a display device and a method for manufacturing the same capable of preventing permeation of moisture or the like.

A display device, according to an embodiment, includes: a substrate; a thin film transistor on (or above) the substrate; a first electrode connected to the thin film transistor; a light emitting layer on the first electrode; and a second electrode on the light emitting layer. The second electrode includes a metal material and a graphene material that are mixed.

The second electrode may include: a first metal layer; a second metal layer above the first metal layer; and a first graphene layer mixed within at least one of the first metal layer and the second metal layer.

The second electrode may further include: a third metal layer above the second metal layer; and a second graphene layer mixed within the third metal layer.

The first metal layer, the second metal layer, and the third metal layer may include the same metal material.

At least one of the first metal layer, the second metal layer, and the third metal layer may include a different metal material from the others of the first metal layer, the second metal layer, and the third metal layer.

The metal material may include at least one of silver and magnesium.

A Raman spectrum result of the second electrode may have I_{d}/I_{G} value of about 0.03 or less and an I_{2D}/I_{G} value of about 1 or more.

A display device, according to another embodiment, includes: a substrate; a thin film transistor on (or above) the substrate; a first electrode connected to the thin film transistor; a light emitting layer on the first electrode; and a second electrode on the light emitting layer and including a metal material and a graphene material. A Raman spectrum result of the second electrode has an I_{d}/I_{G} value of about 0.03 or less and an I_{2D}/I_{G} value of about 1 or more.

The second electrode may include: a first metal layer; a second metal layer above the first metal layer; and a first graphene layer between the first metal layer and the second metal layer.

The first graphene layer may be mixed within the first metal layer or the second metal layer.

The second electrode may further include: a third metal layer above the second metal layer; and a second graphene layer between the second metal layer and the third metal layer.

A method for manufacturing a display device, according to an embodiment, includes: forming a thin film transistor on (or above) a substrate; forming a first electrode connected to the thin film transistor; forming a light emitting layer on the first electrode; and forming a second electrode including a metal material and a graphene material on the light emitting layer. In the forming of the second electrode, the graphene material is deposited by using a plasma enhanced chemical vapor deposition method using plasma.

The forming of the second electrode may include: forming a first metal layer on the light emitting layer; forming a first graphene layer on the first metal layer; and forming a second metal layer on the first graphene layer. The first graphene layer may be formed by using a plasma enhanced chemical vapor deposition method using plasma.

The first graphene layer may be in contact with an upper surface of the first metal layer and a lower surface of the second metal layer, and the first graphene layer may not be mixed within the first metal layer and the second metal layer.

The first graphene layer may be mixed within the first metal layer or the second metal layer.

The first graphene layer may be mixed within the first metal layer, and the first graphene layer may protrude from an upper surface of the first metal layer to contact a lower surface of the second metal layer.

The forming of the second electrode may further include: forming a second graphene layer on the second electrode; and forming a third metal layer on the second graphene layer. The second graphene layer may be formed by using a plasma enhanced chemical vapor deposition method using plasma.

The second graphene layer may be in contact with an upper surface of the second metal layer and a lower surface of the third metal layer, and the second graphene layer may not be mixed within the second metal layer and the third metal layer.

The second graphene layer may be mixed within the second metal layer or the third metal layer.

A Raman spectrum result of the second electrode may have an I_{d}/I_{G} value of about 0.03 or less and an I_{2D}/I_{G} value of about 1 or more.

According to an aspect, there is provided a display device as set out in claim 1. Additional features are set out in claims 2 to 10. According to an aspect, there is provided a method as set out in claim 11. Additional features are set out in claims 12 to 15.

According to embodiments of the present disclosure, permeation of moisture or the like may be prevented in a display device.

### BRIEF DESCRIPTION OF THE DRAWINGS

FIG. 1 is a cross-sectional view illustrating a display device according to an embodiment.
FIGS. 2 to 6 are cross-sectional views illustrating a second electrode of the display device according to various embodiments.
FIGS. 7 to 11 are cross-sectional views sequentially illustrating steps of a method for manufacturing the display device according to an embodiment.
FIGS. 12 to 15 are cross-sectional views sequentially illustrating a process of forming a metal layer of the display device according to an embodiment.
FIG. 16 is a graph showing water vapor transmission rate according to the number of metal layers/graphene layers.

### DETAILED DESCRIPTION

The present disclosure will be described more fully hereinafter with reference to the accompanying drawings, in which embodiments of the present disclosure are shown. As those skilled in the art would realize, the described embodiments may be modified in various different ways, all without departing from the spirit or scope of the present disclosure.

To more clearly describe the present disclosure, parts, portions, or features thereof that are unrelated to the description may be omitted or simplified, and identical or substantially similar constituent elements throughout the specification and the drawings are denoted by the same reference numerals.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

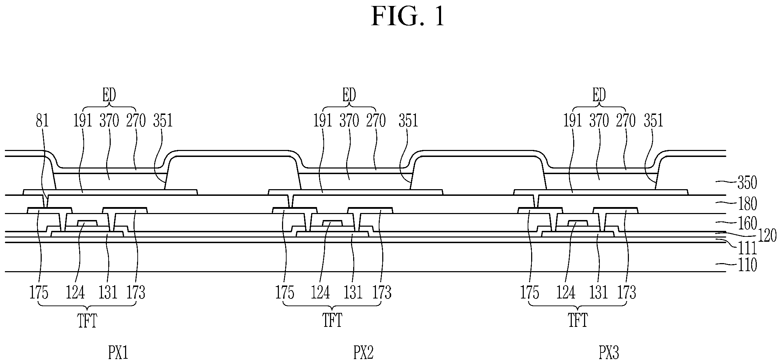

Hereinafter, a display device according to an embodiment will be described with reference to FIG. 1.

FIG. 1 is a cross-sectional view illustrating a display device according to an embodiment.

As shown in FIG. 1, the display device, according to an embodiment, may include a substrate 110, a buffer layer 111, a transistor TFT that is disposed on (or above) one side surface of the substrate 110 and including a semiconductor 131, a gate electrode 124, a source electrode 173, and a drain electrode 175, a gate insulating film 120, a first interlayer insulating film 160, a second interlayer insulating film 180, a first electrode 191, a light emitting layer 370, a pixel defining layer (or a pixel define layer) 350, and a second electrode 270.

The substrate 110 may include a rigid material, such as a glass or the like, or a flexible material, such as a plastic, a polyimide, or the like. The substrate 110 may be flexible, stretchable, foldable, bendable, or rollable. The substrate 110 may have a structure in which a polyimide layer and a barrier layer made of an inorganic insulating material (e.g., an inorganic insulating layer) are alternately stacked. For example, the substrate 110 may have a structure in which a first layer made of a polyimide, a first barrier layer made of an inorganic insulating material, a second layer made of a polyimide, and a second barrier layer made of an inorganic insulating material are stacked.

The buffer layer 111, which flattens a surface (e.g., an upper surface) of the substrate 110 and blocks an impurity from permeating into the semiconductor 131, may be further disposed on the substrate 110. In some embodiments, the buffer layer 111 may be omitted. The buffer layer 111 may include an inorganic material, for example, an inorganic insulating material, such as a silicon nitride (SiNₓ), a silicon oxide (SiOₓ), a silicon oxynitride (SiOₓN_{y}), or the like. The buffer layer 111 may have a single-layer or multi-layer structure of the material(s).

A barrier layer may be further disposed on the substrate 110. In such an embodiment, the barrier layer may be disposed between the substrate 110 and the buffer layer 111. The barrier layer may include an inorganic insulating material, such as a silicon nitride (SiNₓ), a silicon oxide (SiOₓ), a silicon oxynitride (SiOₓN_{y}), or the like. The barrier layer may have a single-layer or multi-layer structure of the material(s).

The semiconductor 131 may be disposed on the buffer layer 111. The semiconductor 131 may include any one of amorphous silicon, polycrystalline silicon, and an oxide semiconductor. For example, the semiconductor 131 may include a low-temperature polysilicon (LTPS) or may include an oxide semiconductor material including at least one of zinc (Zn), indium (In), gallium (Ga), tin (Sn), and a mixture thereof. For example, the semiconductor 131 may include an indium-gallium-zinc oxide (IGZO). The semiconductor 131 may have a channel region, a source region, and a drain region classified according to whether an impurity is doped therein. The source region and the drain region may have a conductivity characteristic corresponding to a conductor. The channel region may be disposed between the source region and the drain region.

The gate insulating film 120 may cover the semiconductor 131 and the substrate 110. The gate insulating film 120 may include an inorganic insulating material, such as a silicon nitride (SiNₓ), a silicon oxide (SiOₓ), a silicon oxynitride (SiOₓN_{y}), or the like. The gate insulating film 120 may have a single-layer or multi-layer structure of the material(s).

The gate electrode 124 may be disposed on the gate insulating film 120. The gate electrode 124 may include a metal, such as copper (Cu), molybdenum (Mo), aluminum (Al), silver (Ag), chromium (Cr), tantalum (Ta), titanium (Ti), or the like, or a metal alloy. The gate electrode 124 may include a single layer or multiple layers. A region of the semiconductor 131 overlapping the gate electrode 124 on a plane may be the channel region.

The first interlayer insulating film 160 may cover the gate electrode 124 and the gate insulating film 120. The first interlayer insulating film 160 may include an inorganic insulating material, such as a silicon nitride (SiNₓ), a silicon oxide (SiOₓ), a silicon oxynitride (SiOₓN_{y}), or the like. The first interlayer insulating film 160 may have a single-layer or multi-layer structure of the material(s).

The source electrode 173 and the drain electrode 175 may be disposed on the first interlayer insulating film 160. The source electrode 173 and the drain electrode 175 are respectively connected to the source region and the drain region of the semiconductor 131 through openings formed in the first interlayer insulating film 160 and the gate insulating film 120. The semiconductor 131, the gate electrode 124, the source electrode 173, and the drain electrode 175 constitute one transistor TFT. According to an embodiment, the transistor TFT may include only the source and drain regions of the semiconductor 131 instead of the source electrode 173 and the drain electrode 175. In FIG. 1, one transistor TFT is shown at each of a first pixel PX1, a second pixel PX2, and a third pixel PX3, but embodiments of the present disclosure are not limited thereto. A plurality of transistors TFT may be disposed at each of the first pixel PX1, the second pixel PX2, and the third pixel PX3.

The source electrode 173 and the drain electrode 175 may include a metal, such as aluminum (Al), copper (Cu), silver (Ag), gold (Au), platinum (Pt), palladium (Pd), nickel (Ni), molybdenum (Mo), tungsten (W), titanium (Ti), chromium (Cr), tantalum (Ta), or the like, or a metal alloy. The source electrode 173 and the drain electrode 175 may include a single layer or multiple layers. The source electrode 173 and the drain electrode 175, according to an embodiment, may have a triple layer structure including an upper layer, an intermediate layer, and a lower layer. The upper layer and the lower layer may include titanium (Ti), and the intermediate layer may include aluminum (Al).

The second interlayer insulating film 180 may be disposed on the source electrode 173 and the drain electrode 175. The second interlayer insulating film 180 covers the source electrode 173, the drain electrode 175, and the first interlayer insulating film 160. The second interlayer insulating film 180 may planarize a surface of the substrate 110 and the transistor TFT, may be an organic insulating film, and may include one or more materials selected from the group consisting of a polyimide, a polyamide, an acrylic resin, benzocyclobutene, and a phenol resin.

The first electrode 191 may be disposed on the second interlayer insulating film 180. The first electrode 191 may also be referred to as an anode electrode and may include a single layer including a transparent conductive oxide film or a metal material or a multi-layer including the transparent conductive oxide film and/or the metal material. The transparent conductive oxide film may include an indium tin oxide (ITO), a poly-ITO, an indium zinc oxide (IZO), an indium gallium zinc oxide (IGZO), an indium tin zinc oxide (ITZO), or the like. The metal material may include silver (Ag), molybdenum (Mo), copper (Cu), gold (Au), aluminum (Al), or the like.

The second interlayer insulating film 180 may include a via hole 81 exposing the drain electrode 175. The first electrode 191 may be physically and electrically connected to the drain electrode 175 through the via hole 81 in the second interlayer insulating film 180. Accordingly, the first electrode 191 may receive an output current to be transferred to the light emitting layer 370 from the drain electrode 175.

The pixel defining layer 350 may be disposed on the first electrode 191 and the second interlayer insulating film 180. The pixel defining layer 350 has a pixel opening 351 overlapping at least a portion of the first electrode 191. The pixel opening 351 may overlap a central portion of the first electrode 191 and may not overlap an edge portion of the first electrode 191 (e.g., the pixel defining layer 350 may cover the edge portion of the first electrode 191). Accordingly, a size of the pixel opening 351 may be smaller than that of the first electrode 191. The pixel defining layer 350 may partition a formation position of the light emitting layer 370 so that the light emitting layer 370 is disposed on a portion where an upper surface of the first electrode 191 is exposed. The pixel defining layer 350 may be disposed at a boundary between the first pixel PX1, the second pixel PX2, and the third pixel PX3. The pixel defining layer 350 may be an organic insulating film including at least one material selected from the group consisting of a polyimide, a polyamide, an acrylic resin, benzocyclobutene (BCB), and a phenol resin. According to an embodiment, the pixel defining layer 350 may be formed of a black pixel define layer (BPDL) including a black pigment.

Each of plurality of pixel openings 351 may have a shape similar to that of the first electrode 191 on a plane. For example, the pixel opening 351 and the first electrode 191 may be formed as a polygon on a plane. In such an embodiment, corner portions of the pixel opening 351 and the first electrode 191 may be chamfered (e.g., rounded). However, a shape of the pixel opening 351 and a shape of the first electrode 191 are not limited thereto and may be variously changed.

A plurality of first electrodes 191 corresponding to the first pixel PX1, the second pixel PX2, and the third pixel PX3 may have different sizes on a plane. Similarly, the plurality of pixel openings 351 corresponding to the first pixel PX1, the second pixel PX2, and the third pixel PX3 may have different sizes on a plane. For example, the pixel opening 351 and the first electrode 191 corresponding to the second pixel PX2 may respectively have a larger size than the pixel opening 351 and the first electrode 191 corresponding to the third pixel PX3 on a plane. In addition, the pixel opening 351 and the first electrode 191 corresponding to the second pixel PX2 may have a smaller size than or a similar size to the pixel opening 351 and the first electrode 191 corresponding to the first pixel PX1 on a plane, respectively. However, embodiments of the present disclosure are not limited thereto, and each pixel opening 351 and each first electrode 191 may have various sizes.

The light emitting layer 370 may be disposed within the pixel opening 351 partitioned by the pixel defining layer 350. However, embodiments of the present disclosure are not limited thereto, and the light emitting layer 370 may be disposed not only within the pixel opening 351 but also on the pixel defining layer 350. For example, the light emitting layer 370 may be entirely formed on (or above) the substrate 110. In such an embodiment, the light emitting layer 370 may be formed by performing a deposition process using an open mask in which a portion corresponding to a display region is open (e.g., is continuously open). The light emitting layer 370 may include a low molecular weight or high molecular weight organic material. The light emitting layer 370 is shown as a single layer but auxiliary layers, such as an electron injection layer, an electron transport layer, a hole transport layer, and a hole injection layer, may also be included above and below the light emitting layer 370. The hole injection layer and the hole transport layer may be disposed below the light emitting layer 370, and the electron transport layer and the electron injection layer may be disposed above or on the light emitting layer 370. In addition, another light emitting layer may be further disposed on the light emitting layer 370. For example, two or more light emitting layers 370 may be stacked.

A spacer may be further disposed above or on the pixel defining layer 350. The spacer may include the same material as the pixel defining layer 350. However, embodiments of the present disclosure are not limited thereto, and the spacer may be made of a material that is different from that of the pixel defining layer 350. The spacer may be an organic insulating film including at least one material selected from the group consisting of a polyimide, a polyamide, an acrylic resin, benzocyclobutene, and a phenol resin.

The second electrode 270 may be disposed on the pixel defining layer 350 and the light emitting layer 370. The second electrode 270 of the first pixel PX1, the second pixel PX2, and the third pixel PX3 may be connected to each other (e.g., may be integrally formed). The second electrodes 270 may be formed to be entirely connected above the substrate 110. The second electrode 270 may include a metal material and a graphene material. The second electrode 270 may act as a cathode electrode, and at the same time, may act as an encapsulation film to prevent moisture from permeating from the outside. The first electrode 191, the light emitting layer 370 and the second electrode 270 may constitute a light emitting device ED. A portion at where the first electrode 191, the light emitting layer 370, and the second electrode 270 overlap each other in the first pixel PX1, the second pixel PX2, and the third pixel PX3 may be a light emitting region (or light emitting regions) of the light emitting device ED.

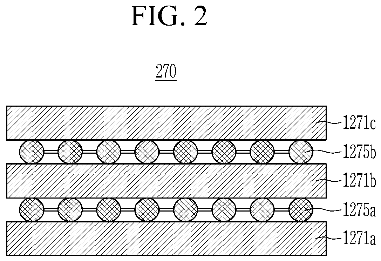

Hereinafter, various structures of the second electrode of the display device according to various embodiments will be described with reference to FIGS. 2 to 6.

FIGS. 2 to 6 are cross-sectional views illustrating the second electrode of the display device according to various embodiments.

As shown in FIG. 2, the second electrode 270 may include metal layers 1271a, 1271b, and 1271c made of a metal material and graphene layers 1275a and 1275b made of a graphene material. The metal layers 1271a, 1271b, and 1271c may include a first metal layer 1271a, a second metal layer 1271b, and a third metal layer 1271c. The graphene layers 1275a and 1275b may include a first graphene layer 1275a and a second graphene layer 1275b. The metal layers 1271a, 1271b, and 1271c and the graphene layers 1275a and 1275b may be alternately stacked. For example, the second electrode 270 includes may have a structure in which the first metal layer 1271a, the first graphene layer 1275a, the second metal layer 1271b, the second graphene layer 1275b, and the third metal layer 1271c are sequentially stacked.

In such an embodiment, the first metal layer 1271a and the first graphene layer 1275a may be in contact with each other but are not mixed. The first graphene layer 1275a and the second metal layer 1271b may contact each other but are not mixed. The second metal layer 1271b and the second graphene layer 1275b may contact each other but are not mixed. The second graphene layer 1275b and the third metal layer 1271c may contact each other but are not mixed.

The metal layers 1271a, 1271b, and 1271c may be made of a metal material, such as silver (Ag), magnesium (Mg), or the like, or a mixture of silver (Ag), magnesium (Mg), and the like. In some embodiments, a thickness of the second electrode 270 may be adjusted to form a transparent conductive layer. In other embodiments, the second electrode 270 may have a translucent property, and such an embodiment, the second electrode 270 may form a microcavity together with the first electrode 191. The first metal layer 1271a, the second metal layer 1271b, and the third metal layer 1271c may be made of the same material.

The graphene layers 1275a and 1275b may include a graphene material. Graphene is a type of carbon allotrope and has a two-dimensional planar crystal structure in a shape of a widely spread hexagonal honeycomb with carbon atoms at vertices of a hexagon. Graphene is a film having a thickness of one atom and exists in a stable structure. Graphene is thin, light, and durable and has high malleability, high electron mobility, high thermal conductivity, a large Young's coefficient, and a large theoretical specific surface area. In addition, because graphene may be formed in a single layer (e.g., in a layer only one atom thick), graphene has low absorption of visible light and has a transmittance of about 97.7 % at 550 nm and may be used in a transparent and flexible electronic device.

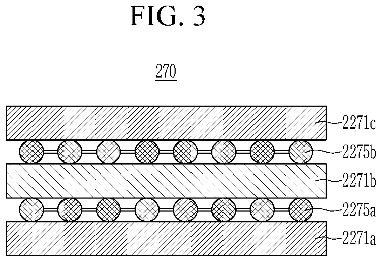

As shown in FIG. 3, the second electrode 270 may include a first metal layer 2271a, a first graphene layer 2275a, a second metal layer 2271b, a second graphene layer 2275b, and a third metal layer 2271c that are sequentially stacked.

In the previous embodiment, the first metal layer 1271a, the second metal layer 1271b, and the third metal layer 1271c may include the same metal material, but in the present embodiment, at least one of the first metal layer 2271a, the second metal layer 2271b, and the third metal layer 2271c may include different metal materials. For example, the second metal layer 2271b may include a different metal material from that of the first metal layer 2271a and the third metal layer 2271c. The first metal layer 2271a and the third metal layer 2271c may include the same metal material.

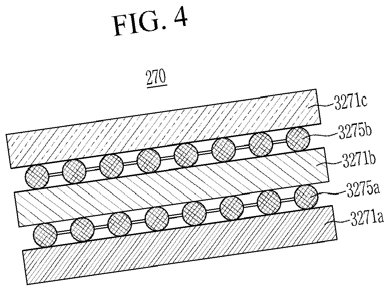

As shown in FIG. 4, the second electrode 270 may include a first metal layer 3271a, a first graphene layer 3275a, a second metal layer 3271b, a second graphene layer 3275b, and a third metal layer 3271c that are sequentially stacked. In this embodiment, the first metal layer 3271a, the second metal layer 3271b, and the third metal layer 3271c may each include different metal materials.

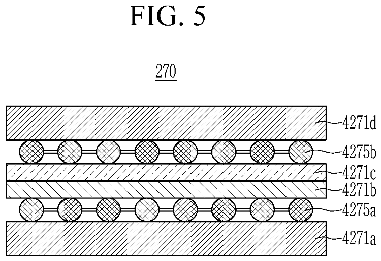

As shown in FIG. 5, the second electrode 270 may include a first metal layer 4271a, a first graphene layer 4275a, a second metal layer 4271b, a third metal layer 4271c, a second graphene layer 4275b, and a fourth metal layer 4271d that are sequentially stacked. In this embodiment, the second metal layer 4271b and the third metal layer 4271c may include different metal materials. The first metal layer 4271a and the fourth metal layer 4271d may include the same metal material. The first metal layer 4271a and the fourth metal layer 4271d may include a different metal material from that of the second metal layer 4271b. The first metal layer 4271a and the fourth metal layer 4271d may include a different metal material from that of the third metal layer 4271c. However, embodiments of the present disclosure are not limited thereto, and the first metal layer 4271a and the fourth metal layer 4271d may include different metal materials. In addition, at least one of the first metal layer 4271a and the fourth metal layer 4271d may include the same metal material as the second metal layer 4271b or the third metal layer 4271c.

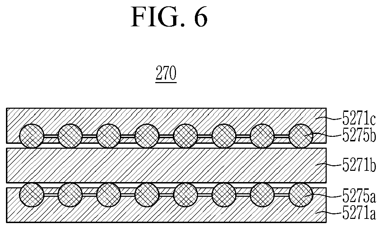

As shown in FIG. 6, the second electrode 270 may include a first metal layer 5271a, a first graphene layer 5275a, a second metal layer 5271b, a second graphene layer 5275b, and a third metal layer 5271c.

The previous embodiments may have a structure in which the metal layer and the graphene layer are separated, but the present embodiment may have a structure in which at least one of the first metal layer 5271a, the second metal layer 5271b, and the third metal layer 5271c and the graphene layer are mixed (or partially mixed). For example, the first graphene layer 5275a may be disposed within the first metal layer 5271a, and the second graphene layer 5275b may be disposed within the third metal layer 5271c. However, this is just one example, and the first graphene layer 5275a or the second graphene layer 5275b may be disposed within another metal layer. For example, the first graphene layer 5275a or the second graphene layer 5275b may be disposed within the second metal layer 5271b.

The first graphene layer 5275a may be disposed closer to an upper surface of the first metal layer 5271a than a lower surface of the first metal layer 5271a. The first graphene layer 5275a may protrude from an upper surface of the first metal layer 5271a, and the first graphene layer 5275a may contact a lower surface of the second metal layer 5271b. The second graphene layer 5275b may be disposed closer to a lower surface of the third metal layer 5271c than an upper surface of the third metal layer 5271c. The second graphene layer 5275b may protrude from a lower surface of the third metal layer 5271c, and the second graphene layer 5275b may contact an upper surface of the second metal layer 5271b. However, embodiments of the present disclosure are not limited thereto, and a position of the first graphene layer 5275a within the first metal layer 5271a and a position of the second graphene layer 5275b within the second metal layer 5271b may be variously changed.

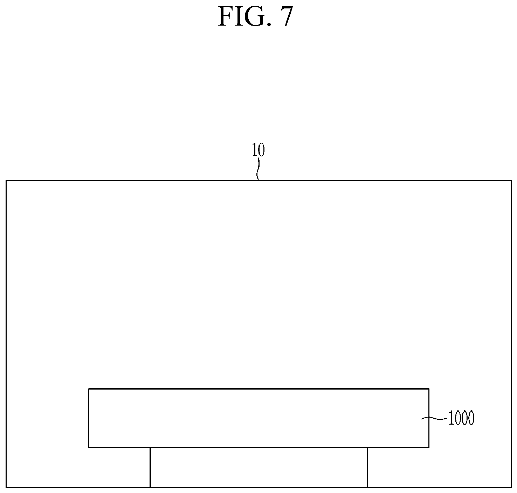

Hereinafter, a method for manufacturing the display device according to an embodiment will be described with reference to FIGS. 7 to 11.

FIGS. 7 to 11 are cross-sectional views sequentially illustrating steps of the method for manufacturing the display device according to an embodiment.

As shown in FIG. 7, a substrate 1000 is disposed within a chamber 10. Although not illustrated, the transistor, the first electrode, the light emitting layer, and a plurality of insulating films disposed between the transistor, the first electrode, and the light emitting layer, as shown and described above, are formed above or on the substrate 1000. Transistors of various structures or the like may be formed above or on the substrate 1000 by various methods, and embodiments of the present disclosure are not limited to a specific structure and method.

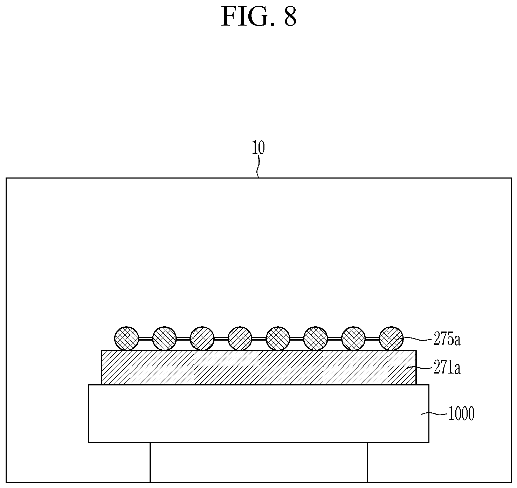

As shown in FIG. 8, a first metal layer 271a is formed by depositing a metal material on the substrate 1000. A plurality of light emitting layers may be disposed above or on the substrate 1000, and the plurality of light emitting layers may be separated by the pixel defining layer. The first metal layer 271a may be disposed above or on the plurality of light emitting layers and the pixel defining layer. The first metal layer 271a may be made of a metal material, such as silver (Ag), magnesium (Mg), or the like, or a mixture of silver (Ag), magnesium (Mg), and the like.

Next, a graphene material is deposited on the first metal layer 271a to form a first graphene layer 275a. In one embodiment, the first graphene layer 275a may be formed by using a chemical vapor deposition (CVD) method. The chemical vapor deposition method may be classified into a thermal CVD method using thermal energy, a plasma enhanced chemical vapor deposition (PECVD) method using plasma, and the like. The first graphene layer 275a may be formed by using the plasma enhanced chemical vapor deposition (PECVD) method using plasma.

The first graphene layer 275a may contact the first metal layer 271a. The first graphene layer 275a is not mixed with the first metal layer 271a. However, embodiments of the present disclosure are not limited thereto, and the first graphene layer 275a may be mixed within the first metal layer 271a (see, e.g., FIG. 6).

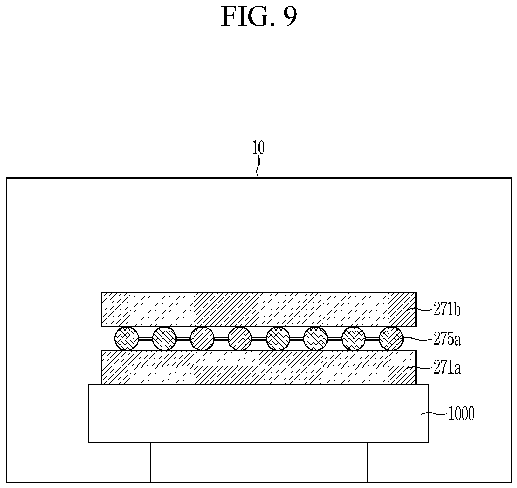

As shown in FIG. 9, a second metal layer 271b is formed by depositing a metal material on the first graphene layer 275a. The second metal layer 271b may contact the first graphene layer 275a. The first graphene layer 275a may be disposed between the first metal layer 271a and the second metal layer 271b. The first graphene layer 275a is not mixed with the second metal layer 271b. However, embodiments of the present disclosure are not limited thereto, and the first graphene layer 275a may be mixed within the second metal layer 271b.

The second metal layer 271b may be made of a metal material, such as silver (Ag), magnesium (Mg), or the like, or a mixture of silver (Ag), magnesium (Mg), and the like. The second metal layer 271b may be formed by using the same material as the first metal layer 271a. However, embodiments of the present disclosure are not limited thereto, and the second metal layer 271b may be formed by using a different material from that of the first metal layer 271a.

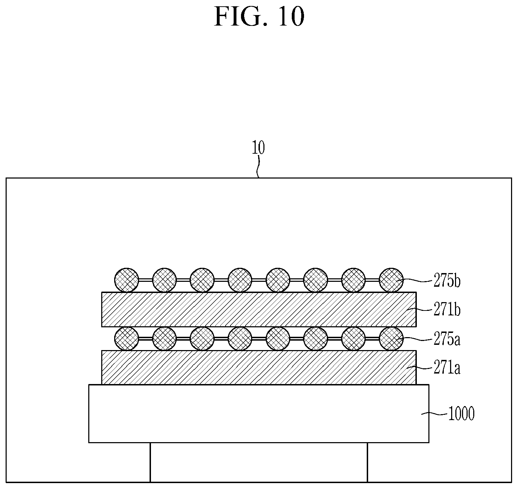

As shown in FIG. 10, a second graphene layer 275b is formed by depositing a graphene material on the second metal layer 271b. In one embodiment, the second graphene layer 275b may be formed by using a plasma enhanced chemical vapor deposition (PECVD) method using plasma.

The second graphene layer 275b may contact the second metal layer 271b. The second graphene layer 275b is not mixed with the second metal layer 271b. However, embodiments of the present disclosure are not limited thereto, and the second graphene layer 275b may be mixed within the second metal layer 271b.

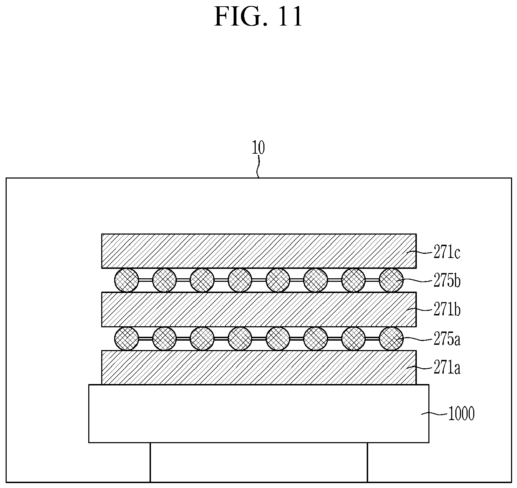

As shown in FIG. 11, a third metal layer 271c is formed by depositing a metal material on the second graphene layer 275b. The third metal layer 271c may contact the second graphene layer 275b. The second graphene layer 275b may be disposed between the second metal layer 271b and the third metal layer 271c. The second graphene layer 275b is not mixed with the third metal layer 271c. However, embodiments of the present disclosure are not limited thereto, and the second graphene layer 275b may be mixed within the third metal layer 271c.

The third metal layer 271c may be made of a metal material, such as silver (Ag), magnesium (Mg), or the like, or a mixture of silver (Ag), magnesium (Mg), and the like. The third metal layer 271c may be formed by using the same material as each of the first metal layer 271a and the second metal layer 271b. However, embodiments of the present disclosure are not limited thereto, and the third metal layer 271c may be formed by using a material that is different from that of each of the first metal layer 271a and the second metal layer 271b. In some embodiments, the first metal layer 271a, the second metal layer 271b, and the third metal layer 271c may be made of different materials. In some embodiments, at least one of the first metal layer 271a, the second metal layer 271b, and the third metal layer 271c may be made of a different material.

Because the depositing of a graphene material by using a thermal chemical vapor deposition method using thermal energy is performed at a process temperature of hundreds of degrees, an element (or a device) that is sensitive to high temperature may be affected. Therefore, if the graphene material is directly deposited on a substrate on which various elements are formed, the elements may be damaged. Therefore, after the graphene material is first deposited on the substrate (e.g., a wafer) on which a high-temperature process may be performed, the graphene layer may be formed on the substrate on which various elements are formed by using a transfer method. The graphene layer formed in this manner may, however, have a low-quality structure with many grain boundaries and defects. The grain boundary is a grain defect that is a boundary between grains, and unlike another portion, the grain boundary is a highly reactive portion. In a Raman spectrum analysis of the low-quality structure, I_{D}/I_{G} may be measured at a level greater than about 0.03, and I_{2D}/I_{G} may be measured at a level less than about 1.

In the display device according to the embodiment, a process may be performed at a low temperature by using a plasma enhanced chemical vapor deposition method using plasma. Therefore, even if the graphene material is directly deposited on the substrate on which various elements are formed without using the transfer method, the elements may not be damaged. The graphene layer formed in this way may have a high-quality structure with few grain boundaries and defects. In a Raman spectrum analysis of the high-quality structure, I_{D}/I_{G} may be measured at a level of about 0.03 or less, and I_{2D}/I_{G} may be measured at a level of about 1 or more. Therefore, in a Raman spectrum analysis of the second electrode of the display device according to the embodiment, I_{D}/I_{G} may be about 0.03 or less, and I_{2D}/I_{G} may be about 1 or more.

There are three Raman peaks found in the graphene layer including a G peak (about 1580 to 1585 cm⁻¹), a 2D peak (about 2680 cm⁻¹), and a D peak (about 1350 cm⁻¹). The G peak is observed as an E2g mode from among phonon modes of graphene and has strong intensity in a normal lattice structure of the graphene. The 2D peak is enhanced by a double resonance phenomenon, and the 2D peak is dispersed and broadened when the graphene is stacked. The D peak is manifested as inelastic scattering by a phonon and strong intensity around a defect/substitution point. Therefore, the higher the I_{D}/I_{G}, the larger the defect area compared with the normal lattice structure of the graphene. In addition, the higher the I_{D}/I_{G}, the lower the number of graphene stacks, and the I_{2D}/I_{G} generally has a value of 1 or more in a case of few-layer graphene (FLG) including several layers.

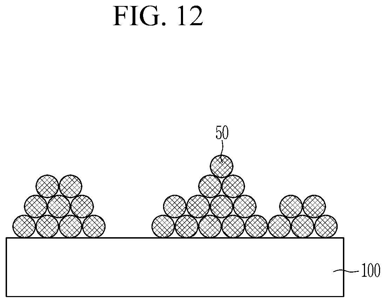

Hereinafter, a process of forming a metal layer constituting the second electrode of the display device according to an embodiment will be described with reference to FIGS. 12 to 15.

FIGS. 12 to 15 are cross-sectional views sequentially illustrating steps of a process of forming the metal layer of the display device according to an embodiment.

As shown in FIG. 12, when the metal material 50 is deposited on a substrate 100, a metal layer in a form of a film is not immediately formed, but metal materials 50 are sparsely (or irregularly) disposed in atomic units.

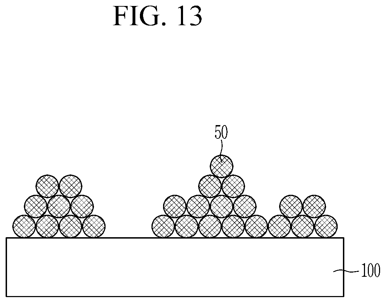

As shown in FIG. 13, when the metal material 50 is continuously deposited, the metal materials 50 gather to form islands. In this case, piles of several island-shaped metal materials 50 may be disposed.

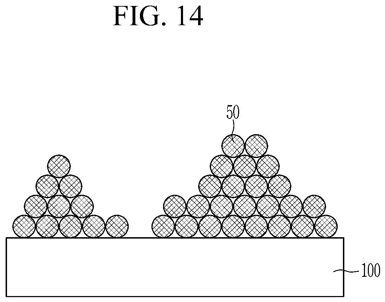

As shown in FIG. 14, when the metal material 50 is continuously deposited, a size of the pile of the island-shaped metal materials 50 gradually increases. As the pile of the island-shaped metal materials 50 increases, a distance between the piles of the metal materials 50 adjacent to each other may become smaller. Eventually, the distance between the piles may become small enough that the piles meet each other.

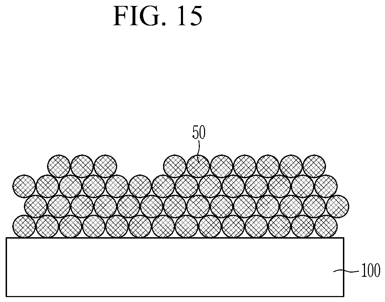

As shown in FIG. 15, when the metal material 50 is continuously deposited, adjacent piles may meet each other to form a film-shaped structure. That is, the metal layer may be formed.

When the metal material 50 is deposited as shown in FIGS. 12 to 15 to form the metal layer in a form of the film, and then the graphene layer is formed by using a plasma enhanced chemical vapor deposition (PECVD) process using plasma, the metal layer and the graphene layer metal layer may have a form in which the metal layer and the graphene layer metal layer are separate from each other. That is, as shown in FIGS. 2 to 5, the metal layer and the graphene layer may be in contact with each other, but the graphene layer may not be mixed with (or within) the metal layer.

When the graphene layer is formed by using a plasma enhanced chemical vapor deposition (PECVD) process using plasma before the metal material 50 is deposited as shown in FIGS. 12 to 14 to form the metal layer in a form of the film, the graphene layer may be mixed within the metal layer. For example, as shown in FIG. 6, the graphene layer may be mixed within the metal layer.

Although the structure in which three or four metal layers and two graphene layers are stacked has been described above, the number of metal layers and the number of graphene layers constituting the second electrode is not limited thereto. The number of metal layers and the number of graphene layers constituting the second electrode may be variously changed.

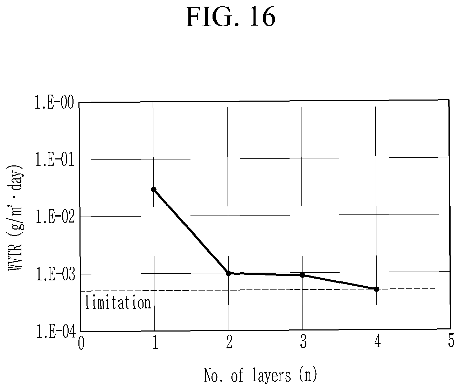

Hereinafter, with reference to Table 1 and FIG. 16, sheet resistance, transmittance, and a water vapor transmission rate (WVTR) according to the number of metal layers/graphene layers constituting the second electrode of the display device according to an embodiment is described as follows. The sheet resistance means resistance of a surface of a material, the transmittance means a degree to which light is transmitted, and the water vapor transmission rate indicates a degree of permeation of moisture per unit area per day.

Table 1 is a table showing the sheet resistance and the transmittance according to the number of metal layers/graphene layers (No. of layers), and FIG. 16 is a graph illustrating the water vapor transmission rate according to the number of metal layers/graphene layers.

**(Table 1)**

| Number of metal layers/graphene layers (No. of layers(n)) | Sheet Resistance (Ω/□) | Transmittance (%) |
|---|---|---|
| 1 | 50 | 97 |
| 2 | 40 | 95 |
| 3 | 12 | 92 |
| 4 | 5 | 90 |

As shown in Table 1, the sheet resistance decreases as the number of stacked metal layers/graphene layers increases. Therefore, in the display device according to an embodiment, a sheet resistance of the second electrode may be sufficiently lowered by alternately stacking metal layers and graphene layers to form the second electrode. For example, the display device according to an embodiment may have a good electrical characteristic. As also shown in Table 1, high transmittance is maintained even when the number of the stacked metal layers/graphene layers increases. For example, even when the metal layer/graphene layer is stacked in four layers, the transmittance may be 90 % or more. Accordingly, the display device according to an embodiment may have high transmittance.

As shown in FIG. 16, the water vapor transmission rate WVTR decreases as the number of the stacked metal layers/graphene layers (No. of layers (n)) increases. When the metal layer/graphene layer is stacked in four layers (n=4), limitation of measurement equipment may be reached. Therefore, in the display device according to an embodiment, the second electrode may have a sufficiently low water vapor transmission rate to block moisture from the outside.

In the display device according to an embodiment, as shown in Table 1 and FIG. 16, a role of the cathode electrode and a role of the encapsulation film may be performed well by stacking several layers of the metal layer and the graphene layer to form the second electrode. In addition, the display device according to an embodiment may have a smaller thickness than a conventional display device including a second electrode made of a metal material and an encapsulation layer made of an organic layer and an inorganic layer. The display device according to an embodiment may have a thin thickness but may exhibit improved electrical characteristics and transmittance. In addition, the display device according to an embodiment may have superior device performance compared with a conventional device when they are applied to a device requiring a low curvature characteristic and a high flexibility characteristic, such as a bendable display device, a rollable display device, or a slidable display device.

Embodiments can provide a display device comprising: a substrate; a thin film transistor on the substrate; a first electrode connected to the thin film transistor; a light emitting layer on the first electrode; and a second electrode on the light emitting layer, the second electrode comprising a metal material and a graphene material that are mixed.

Embodiments can provide a display device comprising: a substrate; a thin film transistor on the substrate; a first electrode connected to the thin film transistor; a light emitting layer on the first electrode; and a second electrode on the light emitting layer and comprising a metal material and a graphene material, wherein a Raman spectrum result of the second electrode has an I_{d}/I_{G} value of 0.03 or less and an I_{2D}/I_{G} value of 1 or more.

Embodiments can provide a display device comprising: a substrate; a thin film transistor on the substrate; a first electrode connected to the thin film transistor; a light emitting layer on the first electrode; and a second electrode on the light emitting layer, the second electrode comprising a metal material and a graphene material.

The second electrode may comprise the metal material and the graphene material that are not mixed. For example, the metal material and the graphene material may be in contact as separate layers (e.g. one or more metal and graphene layers).

In some embodiments, the second electrode may comprise a first metal layer; a second metal layer above the first metal layer; and a first graphene layer between the first metal layer and the second metal layer. The second electrode may further comprise: a third metal layer above the second metal layer; and a second graphene layer between the second metal layer and the third metal layer. Here, the metal layers and the graphene layers may comprise separate layers.

The second electrode may comprise the metal material and the graphene material that are mixed. For example, the graphene material may be disposed within the metal material. For example, the graphene material may comprise a graphene layer disposed within a metal layer.

In some embodiments, the second electrode may comprise a first metal layer; a second metal layer above the first metal layer; and a first graphene layer mixed within at least one of the first metal layer and the second metal layer. The second electrode may further comprise: a third metal layer above the second metal layer; and a second graphene layer mixed within the third metal layer.

For example, the first graphene layer may be disposed within the first metal layer, and the second graphene layer may be disposed within the third metal layer. The first graphene layer may be disposed closer to an upper surface (i.e. facing away from the substrate) of the first metal layer than a lower surface of the first metal layer. The first graphene layer may protrude from an upper surface of the first metal layer, and the first graphene layer may contact a lower surface of the second metal layer. The second graphene layer may be disposed closer to a lower surface of the third metal layer than an upper surface of the third metal layer. The second graphene layer may protrude from a lower surface of the third metal layer, and the second graphene layer may contact an upper surface of the second metal layer.

Embodiments can provide a method for manufacturing a display device, the method comprising: forming a thin film transistor on a substrate; forming a first electrode connected to the thin film transistor; forming a light emitting layer on the first electrode; and forming a second electrode on the light emitting layer, the second electrode comprising a metal material and a graphene material, wherein the graphene material is deposited by using a plasma enhanced chemical vapor deposition method using plasma.

While the present disclosure has been described in connection with what is presently considered to be practical embodiments, it is to be understood that the present disclosure is not limited to the described embodiments but is intended to cover various modifications and equivalent arrangements included within the scope of the appended claims and their equivalents.

### Description of Some Reference Numerals

- 110:: substrate
- 124:: gate electrode
- 131:: semiconductor
- 160:: first interlayer insulating film
- 173:: source electrode
- 175:: drain electrode
- 180:: second interlayer insulating film
- 191:: first electrode
- 270:: second electrode
- 350:: pixel defining layer
- 351:: pixel opening
- 370:: light emitting layer
- 271a, 1271a, 2271a, 3271a, 4271a, 5271a:: first metal layer
- 271b, 1271b, 2271b, 3271b, 4271b, 5271b:: second metal layer
- 271c, 1271c, 2271c, 3271c, 4271c, 5271c:: third metal layer
- 4271d:: fourth metal layer
- 275a, 1275a, 2275a, 3275a, 4275a, 5275a:: first graphene layer
- 275b, 1275b, 2275b, 3275b, 4275b, 5275b:: second graphene layer

## Claims

1. A display device comprising:
a substrate;
a thin film transistor on the substrate;
a first electrode connected to the thin film transistor;
a light emitting layer on the first electrode; and
a second electrode on the light emitting layer, the second electrode comprising a metal material and a graphene material.

2. The display device of claim 1, wherein the second electrode comprises the metal material and the graphene material that are mixed.

3. The display device of claim 2, wherein the second electrode comprises:
a first metal layer;
a second metal layer above the first metal layer; and
a first graphene layer mixed within at least one of the first metal layer and the second metal layer.

4. The display device of claim 3, wherein the second electrode further comprises:
a third metal layer above the second metal layer; and
a second graphene layer mixed within the third metal layer.

5. The display device of claim 6, wherein the first metal layer, the second metal layer, and the third metal layer comprise the same metal material.

6. The display device of claim 6, wherein at least one of the first metal layer, the second metal layer, and the third metal layer comprises a different metal material than the others of the first metal layer, the second metal layer, and the third metal layer.

7. The display device of claim 1, wherein the second electrode comprises:
a first metal layer;
a second metal layer above the first metal layer; and
a first graphene layer between the first metal layer and the second metal layer.

8. The display device of claim 7, wherein the second electrode further comprises:
a third metal layer above the second metal layer; and
a second graphene layer between the second metal layer and the third metal layer.

9. The display device of any one of any one of claims 1 to 8, wherein the metal material comprises at least one of silver and magnesium.

10. The display device of any one of claims 1 to 9, wherein, a Raman spectrum result of the second electrode has an I_{d}/I_{G} value of 0.03 or less and an I_{2D}/I_{G} value of 1 or more.

11. A method for manufacturing a display device, the method comprising:
forming a thin film transistor on a substrate;
forming a first electrode connected to the thin film transistor;
forming a light emitting layer on the first electrode; and
forming a second electrode on the light emitting layer, the second electrode comprising a metal material and a graphene material,
wherein the graphene material is deposited by using a plasma enhanced chemical vapor deposition method using plasma.

12. The method of claim 11, wherein the forming of the second electrode comprises:
forming a first metal layer on the light emitting layer;
forming a first graphene layer on the first metal layer; and
forming a second metal layer on the first graphene layer,
wherein the first graphene layer is formed by using the plasma enhanced chemical vapor deposition method using plasma.

13. The method of claim 12, wherein the first graphene layer is in contact with an upper surface of the first metal layer and a lower surface of the second metal layer, and wherein the first graphene layer is not mixed within the first metal layer and the second metal layer; or
wherein the first graphene layer is mixed within the first metal layer or the second metal layer, optionally wherein the first graphene layer is mixed within the first metal layer, and wherein the first graphene layer protrudes from an upper surface of the first metal layer to contact a lower surface of the second metal layer.

14. The method of claim 12 or 13, wherein the forming of the second electrode further comprises:
forming a second graphene layer on the second electrode; and
forming a third metal layer on the second graphene layer,
wherein the second graphene layer is formed by using the plasma enhanced chemical vapor deposition method using plasma;
optionally wherein the second graphene layer is in contact with an upper surface of the second metal layer and a lower surface of the third metal layer, and wherein the second graphene layer is not mixed within the second metal layer and the third metal layer or wherein the second graphene layer is mixed within the second metal layer or the third metal layer.

15. The method of any one of claims 10 to 14, wherein a Raman spectrum result of the second electrode has an I_{d}/I_{G} value of 0.03 or less and an I_{2D}/I_{G} value of 1 or more.
